(19) Europäisches Patentamt
European Patent Office
Office européen des brevets

(11) **EP 2 579 052 A1**

(12) **EUROPEAN PATENT APPLICATION**
published in accordance with Art. 153(4) EPC

(43) Date of publication:
**10.04.2013 Bulletin 2013/15**

(51) Int Cl.:
*G01R 27/14* (2006.01)   *H03M 1/10* (2006.01)

(21) Application number: **11786045.2**

(22) Date of filing: **18.05.2011**

(86) International application number:
**PCT/CN2011/074262**

(87) International publication number:
**WO 2011/147273 (01.12.2011 Gazette 2011/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.05.2010 CN 201010186731**

(71) Applicants:
• **Zoomlion Heavy Industry Science and Technology Co., Ltd.**
  **Changsha, Hunan 410013 (CN)**
• **Hunan Zoomlion Special Vehicle Co. Ltd.**
  **Changde, Hunan 415106 (CN)**

(72) Inventors:
• **ZHAN, Chunxin**
  **Hunan 410013 (CN)**

• **LIU, Quan**
  **Hunan 410013 (CN)**
• **LI, Xinyi**
  **Hunan 410013 (CN)**
• **GUO, Jimei**
  **Hunan 410013 (CN)**
• **FENG, Songsheng**
  **Hunan 410013 (CN)**

(74) Representative: **Hutter, Jacobus Johannes**
**Nederlandsch Octrooibureau**
**J.W. Frisolaan 13**
**2517 JS The Hague (NL)**

(54) **METHOD FOR MEASURING RESISTANCE VALUE OF CONVERSION RESISTANCE OF CURRENT MODE ANALOG /DIGITAL CONVERTER**

(57)     A method for measuring the resistance value of the conversion resistance of a current mode analog/digital converter, involves keeping a current signal inputted to the current mode analog/digital converter constant (S11); obtaining a first digital quantity $AD_0$ transformed by the current mode analog/digital converter (S12); connecting a resistance $R_j$, of which precision is higher than that of the conversion resistance $R_z$ of the current mode analog/digital converter, with the conversion resistance $R_z$ in parallel (S13); obtaining again a second digital quantity $AD_1$ transformed by the current mode analog/ digital converter (S14); acquiring the resistance value of the conversion resistance $R_z$ by the following formula(I):

$$R_1 = \frac{AD_0 - AD_1}{AD_1} * R_2 \quad (I)$$

wherein, $R_1$ is the acquired resistance value of the conversion resistance $R_z$, and $R_2$ is the resistance value of the resistance $R_j$, of which precision is higher than that of the conversion resistance $R_z$. The method can improve the precision of measuring and controlling the measured physical objects.

*Fig. 1*

keeping a current signal inputted to the current mode A/D converter constant — S11

obtaining a first digital quantity $AD_0$ converted by the current mode A/D converter — S12

connecting a resistor $R_j$ that has an accuracy higher than that of the conversion resistor $R_z$ to the conversion resistor $R_z$ in parallel — S13

obtaining a second digital quantity $AD_1$ converted by the current mode A/D converter — S14

obtaining the resistance value of the conversion resistor $R_z$ according to $AD_0$, $AD_1$ and the resistance value of the resistor that has an accuracy higher than that of the conversion resistor — S15

**Description**

**Technical Field**

The present invention relates to the field of current mode analog-digital (A/D) converters, particularly to a method for measuring the resistance value of the conversion resistor of a current mode A/D converter.

**Background of the Invention**

Typically, in order to realize the detection or control of a physical object under test (such as the rotation angle detected by an angle sensor), a sensor is needed to output the analog current or voltage signal reflecting the change in the physical object under test to an A/D converter, and the A/D converter then converts the said analog signal into a digital signal that can be identified and processed by a computer or PLC. Since a current signal can not directly undergo A/D conversion, it must be converted into a voltage signal at first. For this reason, a conversion resistor is needed, which converts the current signals inputted to the A/D converter into voltage signals.

As there always exists certain deviation in the resistance accuracy of the conversion resistor, when the value of corresponding input analog current signal is calculated based on the digital quantity converted by a current mode A/D converter, the computational accuracy is directly affected by the accuracy of the resistance value of the conversion resistor. For example, a 4-20mA current signal outputted by a sensor is converted into a 1-5V voltage signal via a conversion resistor with a resistance value of 250Ω and then this voltage signal undergoes A/D conversion to convert the current signal into a digital quantity in the range of 13107-65535 (under the circumstance that a 16-bit A/D converter is used). If the resistance accuracy of the conversion resistor is 2%, then the resistance value of the conversion resistor will be 250 ± 5Ω. However, when an operator calculates the value of corresponding input analog current signal using the digital quantity obtained from A/D conversion, he thinks that the resistance value of the conversion resistor is 250Ω (in fact, there exists a deviation of ±5Ω in the resistance value of the conversion resistor), in other words, he thinks that the input current signal corresponding to digital quantity 65535 is 5V/250Ω = 20mA, but the actual value of the input current signal should be 5V/255Ω=19.6mA ~ 5V/245Ω = 20.4mA due to the deviation of resistance value. That is to say, deviation of 2% in the resistance value of the conversion resistor makes the calculated current value also has a deviation of 2%, thereby resulting in a deviation in the value of the measured physical object as reflected by current value.

In the prior art, the following equation (1) is usually used to obtain the actual quantity value of the physical object under test from the converted digital quantity:

$$V = \frac{V_{max} - V_{min}}{AD_{max} - AD_{min}}(AD - AD_{max}) + V_{max} \qquad (1)$$

Wherein, V is the current actual quantity value of the physical object under test, $V_{max}$ is the maximum value of the actual quantity value of the physical object under test, $V_{min}$ is the minimum value of the actual quantity value of the physical object under test, AD is the digital quantity value after A/D conversion, $AD_{max}$ is the digital quantity value corresponding to $V_{max}$ after A/D conversion, and $AD_{min}$ is the digital quantity value corresponding to $V_{min}$ after A/D conversion.

Equation (1) is actually applied to calibrate the A/D converter, however, the possible maximum value $V_{max}$ and possible minimum value $V_{min}$ of the actual quantity values of the physical object under test need to be accurately determined in advance, because the accuracy of the result calculated with Equation (1) largely depends on the accuracy of $V_{max}$ and $V_{min}$ measured by a measuring tool. In order to achieve higher accuracy, a special-purpose measuring tool, such as an electronic angulometer that realizes accurate measurement and has an accuracy of 0.1° should be used to measure the maximum value $V_{max}$ and the minimum value $V_{min}$, because in practice it is difficult to obtain, by an ordinary measuring tool, accurate $V_{max}$ and $V_{min}$ of some physical objects (such as rotation angle) which are difficult to be measured directly. This makes it difficult to achieve high accuracy when detecting or controlling the physical objects under test, thereby limiting the control effect.

**Summary of the Invention**

To overcome the defects in the prior art that it is necessary to use a special-purpose measuring tool to obtain the possible maximum value and minimum value of the actual quantity values of a physical object under test during detection or control of the said physical object, a simple and practicable method for measuring the resistance value of the conversion resistor of a current mode A/D converter is provided to improve the accuracy of measurement and control of the physical object under test.

A method for measuring the resistance value of the conversion resistor of a current mode A/D converter, including:

1) Keeping a current signal inputted to the current mode A/D converter constant;
2) Obtaining a first digital quantity $AD_0$ converted by the current mode A/D converter;
3) Connecting a resistor $R_j$ that has an accuracy higher than that of the conversion resistor $R_z$ of the current mode A/D converter to the conversion resistor $R_z$ in parallel;
4) Obtaining a second digital quantity $AD_1$ converted by the current mode A/D converter; and
5) Obtaining the resistance value of the conversion resistor $R_z$ according to the following equation:

$$R_1 = \frac{AD_0 - AD_1}{AD_1} * R_2$$

Wherein, $R_1$ is the obtained resistance value of the conversion resistor $R_z$, $R_2$ is the resistance value of resistor $R_j$ that has an accuracy higher than that of the conversion resistor $R_z$.

With the foresaid method for measuring the resistance value of the conversion resistor of a current mode A/D converter, as the accuracy of the finally obtained resistance value of the conversion resistor depends on both the conversion accuracy of the A/D converter and the accuracy of the resistor that has an accuracy higher than that of the conversion resistor, and the latter two accuracies are both higher than the nominal resistance accuracy of the conversion resistor, the method according to the present invention can improve the accuracy of the obtained resistance value of the conversion resistor in a simple and practicable way. Consequently, during the measurement and control of the physical object under test, the measurement and control accuracy is improved, too. Moreover, a special-purpose measuring tool is not needed to obtain the possible maximum value and minimum value of the actual quantity values of the physical object under test, so it can measure and control the physical object under test in a simple and practicable way.

## Brief Description of the Drawings

FIG. 1 is a flow diagram of a method for measuring the resistance value of the conversion resistor of a current mode A/D converter in accordance with the present invention.
FIG. 2 is a circuit connection schematic diagram for measurement of the resistance value of the conversion resistor of a current mode A/D converter.

## Detailed Description of the Embodiments

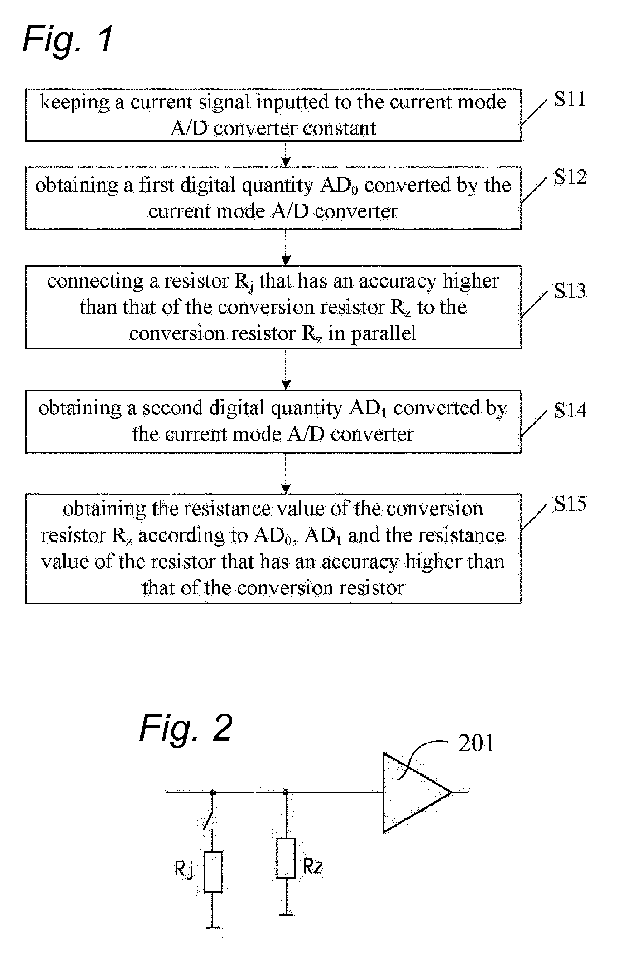

To overcome the defects in the prior art that it is necessary to use a special-purpose measuring tool to obtain the possible maximum value and minimum value of the actual quantity values of a physical object under test during detection or control of the said physical object, a simple and practicable method for measuring the resistance value of the conversion resistor of a current mode A/D converter is provided to improve the accuracy of measurement and control of the physical object under test. As shown in FIG. 1, the method according to the present invention comprises:

S11. Keeping a current signal inputted to the current mode A/D converter constant;
S12. Obtaining a first digital quantity $AD_0$ converted by the current mode A/D converter;
S13. Connecting a resistor $R_j$ that has an accuracy higher than that of the conversion resistor $R_z$ of the current mode A/D converter to the conversion resistor $R_z$ in parallel;
S14. Obtaining a second digital quantity $AD_1$ converted by the current mode A/D converter; and
S 15. Obtaining the resistance value of the conversion resistor $R_z$ according to the following equation:

$$R_1 = \frac{AD_0 - AD_1}{AD_1} * R_2 \qquad (2)$$

Wherein, $R_1$ is the obtained resistance value of the conversion resistor $R_z$, $R_2$ is the resistance value of the

resistor $R_j$ that has an accuracy higher than that of the conversion resistor $R_z$.

With the foresaid method for measuring the resistance value of the conversion resistor of a current mode A/D converter, as the accuracy of the finally obtained resistance value of the conversion resistor depends on both the conversion accuracy of the A/D converter and the accuracy of the resistor that has an accuracy higher than that of the conversion resistor, and the latter two accuracies are both higher than the nominal resistance accuracy of the conversion resistor, the method according to the present invention can improve the accuracy of the obtained resistance value of the conversion resistor in a simple and practicable way. Consequently, during measurement and control of the physical object under test, the measurement and control accuracy is improved, too. Further, a special-purpose measuring tool is not needed to obtain the possible maximum value and minimum value of the actual quantity values of the physical object under test, so it can measure and control the physical object under test in a simple and practicable way.

Further, S11~S14 are performed under constant ambient temperature.

Before S13, the method further comprises: powering off the current mode A/D converter. Further, the resistance value of resistor $R_j$ may be approximate or equal to the nominal resistance value of conversion resistor $R_z$. For example, the resistance value of the conversion resistor $R_z$ is 220Ω and the resistor $R_j$ may be a precision resistor with a resistance value of 250Ω.

As in the flow of S11~S15, the current signal inputted to the current mode A/D converter is kept constant, the change from $AD_0$ to $AD_1$ is in direct proportion to the change in the resistance value of conversion resistor $R_z$ due to the parallel connection of resistor $R_j$, i.e.:

$$\frac{AD_0}{AD_1} = \frac{R_1}{\dfrac{R_1 * R_2}{R_1 + R_2}} \qquad (3)$$

Thereby equation (2) may be obtained from equation (3).

In general, resistor $R_j$ is a precision resistor, with an accuracy of $\pm 0.5\%$ for example; further, the conversion accuracy of the current mode A/D converter is higher than the accuracy of the precision resistor $R_j$. Thus, under the condition that the accuracy of the current mode A/D converter is much higher than the accuracy of the precision resistor $R_j$, if the accuracy of the precision resistor $R_j$ is $\pm 0.1\%$ and the nominal resistance accuracy of the conversion resistor is $\pm 2\%$, then the accuracy of the finally obtained resistance value of the conversion resistor will be about $\pm 0.1\%$, much higher than the nominal accuracy.

Further, since the operating area of engineering machines is vast, the time span is long and the range of variation of ambient temperature in the operating area is wide, for example, from -20°C to 60°C or even wider, so the temperature drift error of the conversion resistor in the current mode A/D converter may also result in the deviation of the value of the physical object under test after A/D conversion. To tackle this problem, the present invention further provides a method for obtaining the resistance values of the conversion resistor $R_z$ at different temperature, i.e.: firstly, obtaining resistance values $R_{1T0}$, $R_{1T1}$ and $R_{1T2}$ of the conversion resistor $R_z$ at ambient temperatures $T_1$, $T_0$ and $T_2$ based on the flow of S11~S15 respectively, wherein $T_0$ is between $T_1$ and $T_2$, and when obtaining $R_{1T0}$, $R_{1T1}$ and $R_{1T2}$, the resistance values of resistor $R_j$ are the resistance values at $T_0$, $T_1$ and $T_2$ (they may be obtained based on the temperature drift characteristic of resistor $R_j$) respectively; then, the resistance value $R_{1T}$ of conversion resistor $R_z$ at any temperature T between $T_1$ and $T_2$ may be approximately obtained by Lagrange quadratic interpolation algorithm:

$$R_{1T} = \frac{(T - T_1)(T - T_2)}{(T_0 - T_1)(T_0 - T_2)} R_{1T0} + \frac{(T - T_0)(T - T_2)}{(T_1 - T_0)(T_1 - T_2)} R_{1T1} + \frac{(T - T_0)(T - T_1)}{(T_2 - T_0)(T_2 - T_1)} R_{1T2} \quad (4)$$

It would be understood that the resistance value $R_{1T}$ of the conversion resistor $R_z$ at any temperature T between $T_1$ and $T_2$ may be obtained by other algorithms according to the temperature drift characteristic and accuracy requirements of the resistor and the number of sampling points. For example, the resistance value $R_{1T}$ of the conversion resistor $R_z$ at any temperature T between $T_1$ and $T_2$ may be obtained by linear algorithm as following:

$$R_{1T} = R_{1T0} + (T - T_0) * \frac{R_{1T1} - R_{1T2}}{T_1 - T_2} \qquad (5)$$

Thus the error caused by temperature drift of the conversion resistor $R_z$ may be compensated so as to improve the accuracy of the measurement and control of the physical object under test.

FIG. 2 shows a circuit connection schematic diagram for measurement of the resistance value of the conversion resistor of a current mode A/D converter, wherein $R_z$ is a conversion resistor, $R_j$ is a resistor that has an accuracy higher than that of the conversion resistor $R_z$, and reference number 201 denotes a current mode A/D converter. The measurement flow by the circuit shown in FIG. 2 is the same as the flow diagram shown in FIG. 1.

It should be understood that various changes, modifications and replacements may be made to the present invention without departing from the spirit and scope of the present invention.

**Claims**

1. A method for measuring resistance value of conversion resistor of a current mode A/D converter, the method comprising:

    1) keeping a current signal inputted to the current mode A/D converter constant;
    2) obtaining a first digital quantity $AD_0$ converted by the current mode A/D converter;
    3) connecting a resistor $R_j$ that has a higher accuracy than that of the conversion resistor $R_z$ to the conversion resistor $R_z$ in parallel;
    4) obtaining a second digital quantity $AD_1$ converted by the current mode A/D converter; and
    5) obtaining the resistance value of the conversion resistor $R_z$ according to the following equation:

$$R_1 = \frac{AD_0 - AD_1}{AD_1} * R_2$$

    wherein $R_1$ is the obtained resistance value of the conversion resistor $R_z$, $R_2$ is the resistance value of the resistor $R_j$ that has a higher accuracy than that of the conversion resistor $R_z$.

2. The method according to claim 1, wherein Step 1) ~ Step 4) are performed under constant ambient temperature.

3. The method according to claim 1, wherein before connecting the resistor $R_j$ that has a higher accuracy than that of the conversion resistor $R_z$ to the conversion resistor $R_z$ in parallel, the method further comprising:

    powering off the current mode A/D converter.

4. The method according to any one of claims 1 to 3, wherein the method further comprising:

    obtaining resistance values $R_{1T0}$, $R_{1T1}$ and $R_{1T2}$ of the conversion resistor $R_z$ at ambient temperatures $T_1$, $T_0$ and $T_2$ according to Step 1) ~ Step 5), respectively;
    obtaining resistance value $R_{1T}$ of the conversion resistor $R_z$ at any temperature T between $T_1$ and $T_2$ by using the following equation according to linear algorithm:

$$R_{1T} = R_{1T0} + (T - T_0) * \frac{R_{1T1} - R_{1T2}}{T_1 - T_2}$$

    wherein, $T_0$ is between $T_1$ and $T_2$.

5. The method according to any one of claims 1 to 3, wherein the method further comprising:

    obtaining resistance values $R_{1T0}$, $R_{1T1}$ and $R_{1T2}$ of the conversion resistor $R_z$ at ambient temperatures $T_1$, $T_0$ and $T_2$ according to Step 1) ~ Step 5), respectively;
    obtaining resistance value $R_{1T}$ of the conversion resistor $R_z$ at any temperature T between $T_1$ and $T_2$ by using the following equation according to Lagrange quadratic interpolation algorithm:

$$R_{1T} = \frac{(T - T_1)\,(T - T_2)}{(T_0 - T_1)\,(T_0 - T_2)}\,R_{1T0} + \frac{(T - T_0)\,(T - T_2)}{(T_1 - T_0)\,(T_1 - T_2)}\,R_{1T1} + \frac{(T - T_0)\,(T - T_1)}{(T_2 - T_0)\,(T_2 - T_1)}\,R_{1T2}$$

wherein, $T_0$ is between $T_1$ and $T_2$.

6.  The method according to claim 1, wherein the accuracy of the resistor $R_j$ is lower than the conversion accuracy of the current mode A/D converter.

7.  The method according to claim 6, wherein the accuracy value of the resistor $R_j$ is in the range of $\pm 0.5\%$.

## Fig. 1

keeping a current signal inputted to the current mode A/D converter constant — S11

obtaining a first digital quantity $AD_0$ converted by the current mode A/D converter — S12

connecting a resistor $R_j$ that has an accuracy higher than that of the conversion resistor $R_z$ to the conversion resistor $R_z$ in parallel — S13

obtaining a second digital quantity $AD_1$ converted by the current mode A/D converter — S14

obtaining the resistance value of the conversion resistor $R_z$ according to $AD_0$, $AD_1$ and the resistance value of the resistor that has an accuracy higher than that of the conversion resistor — S15

## Fig. 2

201

Rj    Rz

# INTERNATIONAL SEARCH REPORT

International application No.

PCT/CN2011/074262

### A. CLASSIFICATION OF SUBJECT MATTER

See extra sheet

According to International Patent Classification (IPC) or to both national classification and IPC

### B. FIELDS SEARCHED

Minimum documentation searched (classification system followed by classification symbols)

IPC:G01R, H03M

Documentation searched other than minimum documentation to the extent that such documents are included in the fields searched

Electronic data base consulted during the international search (name of data base and, where practicable, search terms used)

CNPAT,CNKI:

DWPI,SIPOABS:ADC, analog+ digital conver+, AD conver+，resistance?, resistor?, current type, current mode, parallel+, shunt, conversion, converting, transition, accuracy, accurate, precise, precision, exact+, delicate

### C. DOCUMENTS CONSIDERED TO BE RELEVANT

| Category* | Citation of document, with indication, where appropriate, of the relevant passages | Relevant to claim No. |
|---|---|---|
| P,X | CN102043093A (CHANGSHA ZHONGLIAN HEAVY IND. TECHNOLOGY) 04May2011 (04.05.2011) Claims1-7 | 1-7 |
| A | JP59214776 A(HIOKI ELECTRIC WORKS) 04 Dec.1984(04.12.1984) line 1 in the right upper column on page 2-line 2 in the right lower column on page 3 of the description, Figs.2,3 | 1-7 |
| A | EP1072896A2(HONEYWELL AG.)31 Jan.2001(31.01.2001) the whole document | 1-7 |
| A | JP3937642B2 (SONY CORP.)27 Jun. 2007(27.06.2007) the whole document | 1-7 |

☐ Further documents are listed in the continuation of Box C.        ☒ See patent family annex.

| | |
|---|---|
| *   Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim (S) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"document member of the same patent family |

| Date of the actual completion of the international search | Date of mailing of the international search report |
|---|---|
| 11Aug.2011(11.08.2011) | **25 Aug. 2011 (25.08.2011)** |

| Name and mailing address of the ISA/CN The State Intellectual Property Office, the P.R.China 6 Xitucheng Rd., Jimen Bridge, Haidian District, Beijing, China 100088 Facsimile No. 86-10-62019451 | Authorized officer MIAO,Wen Telephone No. (86-10)62085340 |
|---|---|

Form PCT/ISA /210 (second sheet) (July 2009)

## INTERNATIONAL SEARCH REPORT
### Information on patent family members

| | International application No. |
|---|---|
| | PCT/CN2011/074262 |

| Patent Documents referred in the Report | Publication Date | Patent Family | Publication Date |
|---|---|---|---|
| CN102043093A | 04.05.2011 | NONE | |
| JP59214776 A | 04.12.1984 | NONE | |
| EP1072896A2 | 31.01.2001 | EP1072896B1 | 17.06.2009 |
| | | EP1072896A3 | 16.08.2001 |
| | | DE19934644 A1 | 01.03.2001 |
| | | DE50015661D | 30.07.2009 |
| | | DE19934644 C2 | 02.05.2002 |
| | | AT434188T | 15.07.2009 |
| JP3937642B2 | 27.06.2007 | JP2000278129A | 06.10.2000 |

# INTERNATIONAL SEARCH REPORT

International application No.

PCT/CN2011/074262

Continuation: A.CLASSIFICATION OF SUBJECT MATTER

G01R27/14 (2006.01) i
H03M1/10 (2006.01) i

Form PCT/ISA /210 (extra sheet) (July 2009)